# EUROPEAN PATENT SPECIFICATION

(11) **EP 0 972 853 B1**
(45) Date of publication and mention of the grant of the patent: **16.10.2002**
(21) Application number: 99305594.6
(22) Date of filing: 14.07.1999
(51) Int. Cl.: C23C 28/00, C23C 14/08, C23C 14/24, F01D 5/28

(54) **Article having a thermal barrier coating based on a phase-stable solid solution of two ceramics and apparatus and method for making the article**
Erzeugnis mit einer Wärmedämmschicht, welche aus einer phasenstabilen festen Lösung von zwei Metalloxiden besteht, sowie Anlage und Verfahren zur Herstellung
Article revêtu d'une couche de barrière thermique à base d'une solution solide à phase stable, et appareil et procédé pour la fabrication

(30) Priority: 17.07.1998 US 118540; 17.07.1998 US 118285; 17.07.1998 US 118289
(43) Date of publication of application: 19.01.2000
(73) Proprietor: UNITED TECHNOLOGIES CORPORATION, Hartford, CT 06101 (US)
(72) Inventor: Maloney, Michael J., Port St. Lucie, Florida 34983 (US)
(74) Representative: Leckey, David Herbert

(56) References cited:
- EP-A- 0 441 095
- WO-A-98/26110
- WO-A-99/27149
- GB-A- 770 077
- US-A- 4 299 865
- US-A- 4 632 059
- US-A- 5 334 462
- PATENT ABSTRACTS OF JAPAN vol. 007, no. 003 (C-143), 7 January 1983 (1983-01-07) & JP 57 161061 A (TOKYO DENKI KAGAKU KOGYO KK), 4 October 1982 (1982-10-04)

## Description

The present invention relates generally to thermal barrier coatings (TBCs) and relates more particularly to articles having a ceramic TBC and to apparatus and methods for making such articles.

Electron beam physical vapor deposition (EB-PVD) is one method for coating substrates or other components with thin layers of columnar grain coatings, and is typically performed within a sealed chamber that is maintained at a low gas pressure. The application of ceramic TBCs to substrates fabricated from superalloys is known, for example from U.S. Pat. Nos. 4,321,311 to Strangman, which discloses columnar grain ceramic thermal barrier coatings; 4,405,659 to Strangman, which discloses a method for producing columnar grain ceramic TBCs; 4,405,660 to Ulion et al, which discloses a method for producing metallic articles having durable ceramic TBCs; and 5,087,477 to Giggins, Jr. et al., which discloses an EB-PVD method for applying ceramic coatings.

During EB-PVD, an electron beam impinges upon a coating target provided in solid form, e.g., as a stick or rod of material. The target is held in a cooled crucible, generally in the shape of a hollow cylinder. The beam heats the exposed end of the target, thereby forming a molten pool of target material. The material vaporizes, and the vapor or evaporant fills the chamber and condenses upon the surface of the substrate to form the coating. One such target/coating material is yttria stabilized zirconia (YSZ), which is characterized by constituents having similar vapor pressures. Accordingly, the constituents tend to vaporize at similar rates, and the composition of the resultant TBC corresponds to the composition of the target.

The general purpose of TBCs is, of course, to reduce heat flow into the component, thereby protecting the substrate. In aircraft applications, and particularly with respect to the first several turbine stages, turbine blades and vanes are subjected to gas temperatures of up to 2500-3000° F (1371-1649°C), which are well above the melting point of the underlying substrate. The TBC therefore must have a low thermal conductivity and usually the component must also be cooled. However, providing cooling air to the component reduces the operating efficiency of the turbine.

One known target/coating material is yttria stabilized zirconia (YSZ), which is characterized by constituents having similar vapor pressures. Accordingly, the constituents tend to vaporize at similar rates when heated, and the composition of the resultant coating corresponds to the composition of the target. 7YSZ, YSZ including about 7 wt% yttria, applied by EB-PVD has a relatively constant thermal conductivity of about 15-20 Btu-in./(hr-ft²-°F) or about 2 - 2.5 W/(m-°C), between about room temperature and about 2200° F( 204°C). Its thermal conductivity tends to increase with increasing temperature. While YSZ has served as a satisfactory TBC for a number or years, lower thermal conductivity TBCs are desired.

A TBC having lower thermal conductivity offers several advantages for aircraft and other gas turbine applications. Given a constant TBC thickness and gas temperature, blade/vane temperatures are lowered thereby extending blade/vane life. Given a constant coating thickness and metal temperature, higher gas temperatures are possible thereby improving efficiency. Given a constant gas temperature and constant metal temperature, thinner coatings may be utilized, which greatly reduces the pull exerted by a rotating blade and enables use of smaller, lighter disks and/or increased creep life. Moreover, thinner coatings are expected to be more durable than thicker coatings, to the extent that thermal stresses in the thicker coatings are believed to contribute to TBC failure. Variations of the above, e.g., application of a somewhat thinner TBC and operation at a somewhat higher gas temperature, may also be desirable.

In an effort to generate TBCs having improved characteristics such as reduced thermal conductivity, other combinations of constituents have been utilized. U.S. Pat. No. 5,334,462 to Vine et al. discloses a ceramic insulating material and insulating coating made thereof. The coating material is a yttria strengthened ceria. The addition of a small amount of yttria, e.g., 0.5 wt% (0.5 percent by weight) significantly hardens the ceria, and provides a material which is useful as a TBC. It was suggested that the above-noted beneficial effects of yttria strengthened ceria apply up to, or even above, the solid solubility limit of yttria in ceria, which is about 12 wt% yttria.

Test applications of this material applied by EB-PVD, in which a unitary, solid source of yttria and ceria target material is employed, indicate that EB-PVD does not provide TBCs with a percentage of yttria comparable to the target. It is believed that since the ceria has a significantly higher vapor pressure than yttria, the resulting TBC necessarily has a significantly lower weight percentage of yttria than does the target. As noted in Vine et al., a target having 9 wt% yttria results in a TBC having only 0.5 wt% yttria using the above-described EB-PVD techniques. Moreover, solid single source targets of constituents which are not miscible, tend to crack during heating due to the thermal gradients that are generated between the two distinct constituents.

In addition, it is preferable that TBCs also exhibit erosion resistance.

It is a general object of the present invention to generate an article having an improved ceramic TBC.

It is also a general object of the present invention to provide an apparatus, and a method, for producing mixtures of two or more evaporants to form TBCs.

It is a more specific object of the invention in its preferred embodiments at least to provide a TBC having a lower thermal conductivity than known TBCs.

It is a more specific object of the invention in its preferred embodiments at least to provide an apparatus capable of, and a method for, adjusting the amounts of the constituents in the vapor flux, and thereby adjusting the composition of the TBC.

It is another, more specific object of the invention in its preferred embodiments at least to provide a TBC composed of materials having significantly different vapor pressures, for example yttria and ceria, and to provide an apparatus and method to produce with a TBC.

From a first aspect, the invention provides a superalloy article as claimed in claim 1.

From a second aspect the invention provides a superalloy article as claimed in claim 2.

The article may include a ceramic bond coat, such as a layer of yttria strengthened zirconia, between the alumina layer and the barrier coating.

The invention also extends to apparatus for producing a TBC on an article. JP 57 161061 discloses a crucible for evaporating metals for use in producing magnetic recording media. The present invention from a further broad aspect, provides an apparatus as claimed in claim 9.

The present invention also extends to a method of generating a ceramic thermally insulating coating on an article as claimed in claim 14.

Some preferred embodiments of the present invention will now be described, by way of example only, with reference to the accompanying drawings in which:
Fig. 1 is a cross sectional line drawing of an article having a TBC in accordance with the present invention.
Fig. 2 is a schematic view of an apparatus including a crucible for generating a TBC in accordance with the present invention.
Figs. 3a and 3b are additional views of the crucible of Fig. 2.
Fig. 4 is a portion of a phase diagram of yttria and ceria.

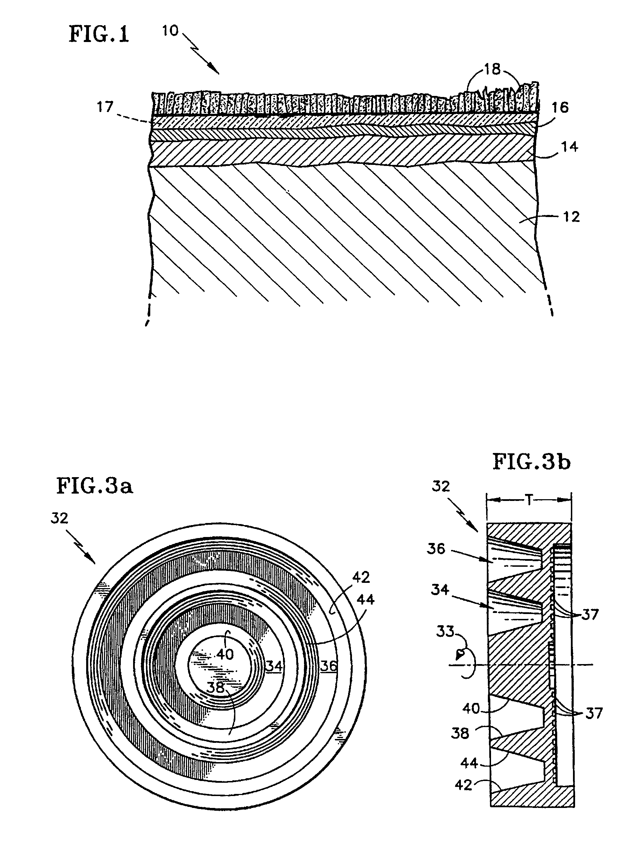

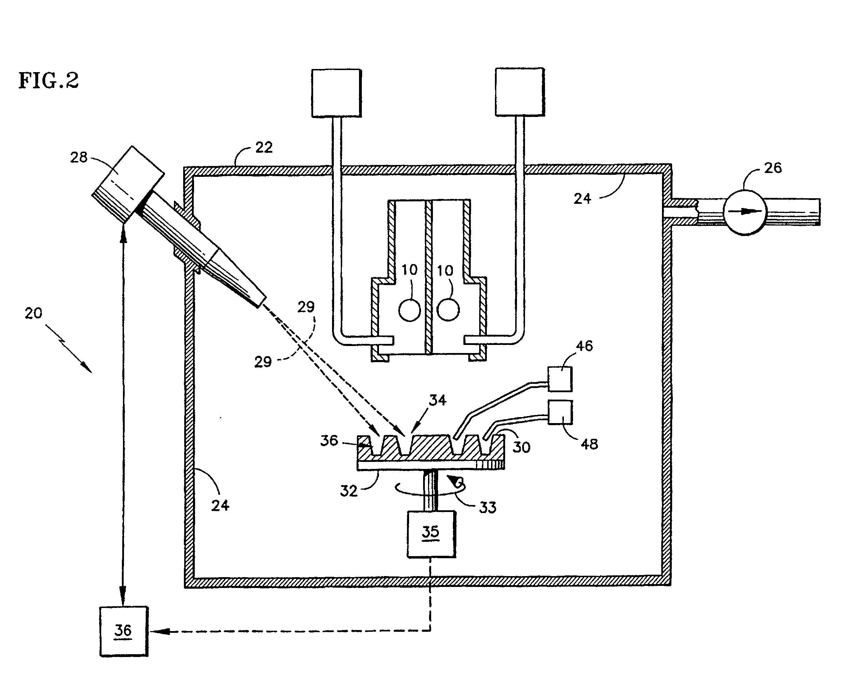

Turning now to Fig. 1, which is not a scale drawing, a portion of an article according to the present invention is illustrated generally by the reference numeral 10. The article has a metallic bond coat, as well as a novel thermal barrier coating (TBC). U.S. Pat. Nos. 4,405,659 to Strangman, 5,087,477 to Giggins et al. and 5,514,482 to Strangman generally describe the application of a metallic bond coat and a TBC to an article, such as an air cooled turbine article made from a superalloy material.

A substrate 12 such as a superalloy substrate is coated with a layer 14 of MCrAIY, intermetallic aluminide or other suitable material which serves as a metallic bond coat (if needed) between the metal substrate and the TBC. Preferably although not necessarily, the layer 14 thickness is between about 2 to 10 mils (0.05-0.25 mm) and is uniform. The layer may also be treated, e.g., by peening, polishing and/or heat treating, to densify any voids and to improve the structure of the coat and adherence to the substrate. A thin alumina layer 16 is formed on the metallic bond coat 14, although the alumina layer may be formed after application of the TBC; depending upon the particular material used for the substrate, the alumina layer may be formed directly on the substrate such that the application of a separate metallic bond coat is not necessary. See, e.g., U. S. Pat. No. 4,719,080 to Duhl and 5,262,245 to Ulion et al. The TBC 18 is then deposited on the alumina layer, for example by electron beam physical vapor deposition (EB-PVD) or other suitable technique. Strangman '659 and Giggins et al. '477 discuss TBCs composed of yttria stabilized zirconia (YSZ). While the present invention has particular utility for generating a TBC from target materials having different vapor pressures, such as yttria and ceria, the present invention may equally be employed with other materials including materials having similar vapor pressures.

As noted in U.S. Pat. No. 5,334,462 to Vine et al., the addition of small amounts of yttria to ceria results in a material having desirable properties such as increased hardness. Vine suggests that the desirable properties are produced where the ceria has up to about 5 wt% (percent by weight) of yttria. Vine also notes that where yttria and ceria are deposited by EB-PVD, the composition of a target does not correspond generally to the composition of the resulting TBC. As an example, a target containing about 9 wt% yttria resulted in a TBC having only about 0.5 wt% yttria. Accordingly, the prior art suggests that it is not possible to continually increase the yttria content of the resulting TBC merely by increasing the yttria content of the target, particularly where the TBC is generated using EB-PVD.

In general, the present invention utilizes independent vaporization of physically separate target materials, to produce a mixture of evaporants and enable adjustment of the composition of the resulting TBC. Where one of the target materials has a vapor pressure significantly lower than the other material(s), it is possible to adjust the relative amounts of the materials vaporized, and thereby adjust the composition of the resulting TBC as desired. For example, where yttria and ceria are to be applied as a TBC using EB-PVD, the present invention permits the generation of a TBC having a yttria content significantly higher than was possible compared to the prior art.

Turning now to Fig. 2, an apparatus 20 is shown for utilizing EB-PVD to generate a TBC from two target materials, such as yttria strengthened ceria TBC having a relatively high yttria content. Other apparatus, other application methods, such as sputtering, and other materials may also be utilized with the invention. In the illustrated case, portions of the apparatus 20 are similar to the apparatus shown and described in U.S. Pat. No. 5,087,477 to Giggins et al. and entitled "EB-PVD Method For Applying Ceramic Coatings". The apparatus 20 includes a sealed coating chamber 22 defined by walls 24, 24, and means 26 such as a vacuum unit for evacuating the chamber. At least one device, such as an electron beam gun 28, is provided for heating and evaporating any target materials contained in a crucible 30, which differs significantly from prior art crucibles.

A part 10 to be coated is held in spaced relation to the target and may be moved or otherwise manipulated with respect to the target, as is known in the art. The gun 28 includes a built-in magnetic field generator (not shown) for deflecting a beam 29 produced by the gun, as is known in the art. In the prior art, such deflection is utilized to scan the beam across the target material, which is typically cylindrical in shape and up to about 75 mm (3 in.) in diameter. The crucible 30 differs significantly from the prior art and is positioned on a carousel 32, which rotates the crucible to transport target material into the path of the beam, where the target material is vaporized, as described further below. The carousel is rotated as indicated by arrow 33 by a motor 35 under the direction of control unit 36 in the manner described below. While various target-to-substrate separations may be employed to produce a satisfactory TBC, we have used a separation of about 3.5 inches (88 mm).

The crucible 30 is shown in greater detail in Figs. 3a and 3b. The crucible is preferably fabricated from copper, and is liquid cooled as is known in the art. Liquid such as water is passed through cooling passages 37 provided in the crucible.

In a departure from the prior art crucibles, the crucible of the present invention provides two or more target materials separately from one another. In the preferred embodiment, the crucible is disk-shaped and defines a pair of channels 34, 36, although more channels could be provided. The channels receive separate or physically distinct constituents of the TBC, and are physically separate from, but adjacent to one another. In the illustrated case, one channel 34 contains yttria and the other channel 36 contains ceria.

If desired, additional channels could be provided, or the constituents could incorporate amounts of other oxides, including but limited to zirconia, hafnia, lanthia, calcia and scandia. Evaporation, and subsequent condensation of these materials on a substrate will result in a TBC characterized by a limited substitution of these other oxides for yttria and/or ceria on the cation sublattice, which may produce other desirable properties in the TBC.

The particular dimensions of the crucible are not believed to be critical to the invention. The channels should be separated from one another sufficiently so that the constituents can be vaporized independently of one another. The channels should be in sufficiently close proximity that the vaporized materials can form a homogeneous mixture prior to condensing upon the article. The channels are preferably but not necessarily arcuate (more preferably circular) and concentric, to provide a continuous feed path to the beam while the carousel is rotated. The illustrated crucible 32 has a thickness T of about 1.5 inches (38 mm), and the channels are each about an inch deep and defined by sloped walls 38, 40 and 42, 44. The bottom portion of the walls 38, 40 and 42, 44 of a given channel are separated from one another by about 0.5 inch (13 mm), and the top portion of the wall 38 of one channel is separated from the adjacent wall 44 portion of the other channel by about 0.25 inch (6 mm). If needed, target material is continuously added to the channels by hoppers 46, 48 of the respective constituent material, located away from where the material is vaporized.

As noted above, the yttria and ceria are provided in separate channels, and are provided as a "gravel", preferably having a particle size of at least about 2 mm and more preferably about 3 - 5 mm. Coarser material may also be used. When finer material has been used, the smaller particles have tended to be displaced from the channel during vaporization of adjacent material, e.g., the smaller particles tend to be blown from the channel prior to being vaporized. Accordingly, particles finer than about 2 mm, and preferably about 3 mm are not generally used. As noted above, additional yttria and ceria may be added to the crucible by hoppers 46, 48, or other suitable mechanisms.

Having described the apparatus, the operation of the apparatus is now described. With reference to Fig. 2, the part 10 to be coated has been formed, a metallic bond coat 14 (Fig. 1) has been applied (if appropriate) and the alumina layer 16 has been formed, as is known in the art.

The part 10 is placed in the chamber 22 and the chamber is evacuated to a pressure appropriate for the application of the TBC, typically less than about 10⁻⁴ torr. The TBC is then applied, for example by EB-PVD. Regardless of how the TBC is applied, it is believed to be important to control the substrate temperature during TBC application.

Where YSZ or YsCeO₂ is applied by EB-PVD, the substrate temperature should be at least about 950° C or 1750° F, although the actual temperature may vary by material and equipment operating parameters. The substrate is initially heated either by the gun or using external heaters (not shown), and heat is also supplied to the substrate indirectly by the gun during vaporization of the target, to maintain substrate temperature.

Test samples of yttria-strengthened-ceria (YsCeO₂) have indicated a relatively poor adherence of the TBC to the alumina layer where the substrate is not sufficiently heated during TBC application. The tests have also indicated that the heat produced during vaporization of yttria and ceria by EB-PVD is not sufficient to maintain proper substrate temperature. Accordingly, additional heaters should be employed.

We have found that applying a thin layer of a ceramic such as YSZ onto the alumina layer prior to applying the yttria and ceria provides an adequate adherent layer, or ceramic bond coat, for the yttria strengthened ceria layer, even if additional, external heaters are not employed to heat the substrate during application of the yttria and ceria or if the appropriate substrate temperature is otherwise not maintained.

In Fig. 1, the ceramic bond coat layer is indicated in dashed lines at 17. In one test, the layer was composed of 7YSZ applied by EB-PVD, and was about 0.5 mils (0.01 mm) thick although the layer may have a different thickness, e.g., up to several mils. The ceramic bond coat should be thick enough to ensure that the alumina layer is substantially completely covered; however, where the ceramic bond coat is used on a rotating part such as turbine blade the layer should be no thicker than necessary to effect this purpose, as this additional layer will contribute to significant blade pull. It is believed that sputtering will also provide a satisfactory YSZ ceramic bond coat layer. Microscopic examination of samples including the YSZ layer has indicated that epitaxial growth occurs across grain boundaries between the YSZ and the yttria strengthened ceria. Moreover, the YSZ layer offers some thermal resistance in the event that the outer TBC fails.

In order to apply a TBC using a mixture of two separate constituents, each of the constituents must be heated and vaporized. In the illustrated case, only a single electron beam gun is employed, and includes a built-in variable magnetic field generator for deflecting the beam, as is known in the art. An external magnetic field generator may be used in the event that the gun does not include a built-in magnetic field generator or if the built-in generator lacks desired operating characteristics. In the prior art, such deflection is utilized to more evenly heat a conventional target.

With reference to Figs. 2 and 3b, the beam 29 is scanned back and forth between the channel 34 and the channel 36 to vaporize each of the target materials. The scan rate must be slow enough to enable the beam to impinge upon and vaporize the target material, but fast enough to ensure that both constituents exist simultaneously in vapor form in the chamber 22. We do not believe that the beam can be scanned too fast, apart from equipment limitations. If only one constituent exists as vapor at a given time, the resulting TBC is characterized by discrete layers of target material. As used herein, a "scan" includes one path of movement of the beam, from a starting point and over a constituent in one channel, translation of the beam to the other channel, over another constituent in the other channel, back over the another constituent and then back across the one constituent. We believe that it is preferable to scan the beam faster rather than slower, e.g., at least about 3 times per second and preferably at least about 10 times per second.

The time during which the beam impinges upon the target material, i.e., the dwell time of the beam, is important. A longer dwell time on the material provides more heat to that target, thereby vaporizing more of the target than does a shorter dwell time. The dwell time on each target may be adjusted based in part upon the relative vapor pressures of the target, as well as the desired TBC composition, e.g., the beam dwells longer on a material if it is desired to increase the content of that material in the TBC.

As the beam is being scanned, the carousel 32 is rotating. Rotation occurs fast enough to continuously provide material to be vaporized, but slowly enough to enable the beam to impinge repetitively upon and vaporize material. For the material and the crucible described above, the preferred rotation rate is about 3 rpm or less. Particle size will also affect the rate at which the carousel should be rotated, with larger particles generally requiring slower carousel rotation. Scanning the beam while rotating the crucible also helps prevent vaporization of crucible material, since the beam will not repeatedly dwell upon any one portion of the crucible for a significant time period. Both target materials exist in vapor form, such that the vapors are uniformly interspersed, e.g., the vapors form a generally homogeneous mixture, prior to condensing on the part and forming the TBC layer 18 (Fig. 1).

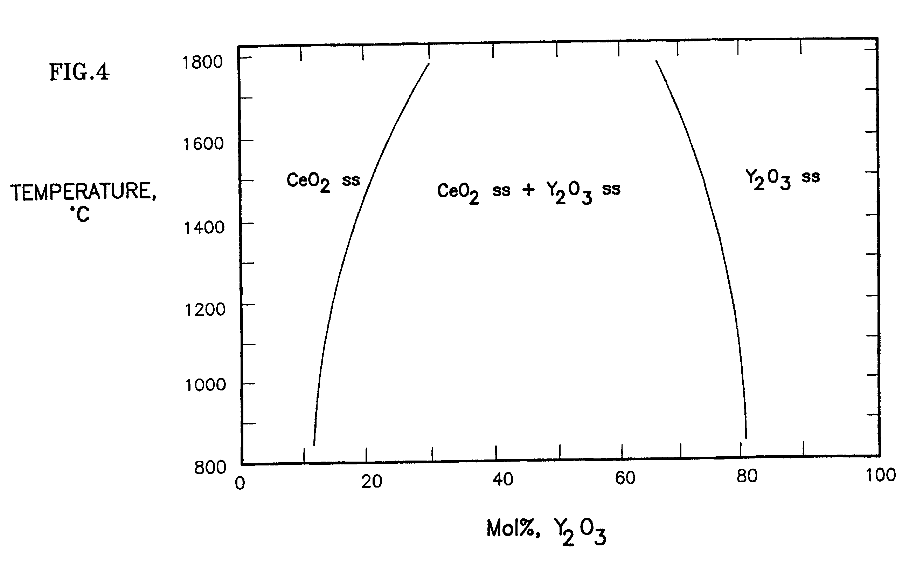

Fig. 4 shows a partial phase diagram for yttria and ceria. As indicated in the diagram, yttria and ceria having up to about 12 wt% (equivalent to about 9.4 mol. %) YsCeO₂ exists as a single phase and is stable up to at least about 2700° F (1482°C). It is believed that the method of the present invention can produce TBCs having substantially higher yttria content, e.g., greater than 12 wt% yttria, and that such TBCs may also have utility as TBCs even though the material may include multiple phases. As indicated in Fig. 4, such a TBC is expected to include more than one phase.

The thermal conductivity of columnar YsCeO₂ decreases with increasing temperature, at least within the range of between about 60 - 2200+°F (16-1204°C). In other words, the thermal conductivity of YsCeO₂, specifically, 9 YsCeO₂ actually decreases significantly over that temperature range, from less than about 2.5 W/(m °C) at room temperature to less than about 1.0 above 2000°F (1093°C). Increased yttria content of YsCeO₂ provides further reductions in thermal conductivity. We have tested samples of 50 YsCeO₂ (comprised of 50 wt% yttria and 50 wt% ceria), which was applied by EB-PVD, with favorable results. The samples had a thermal conductivity of between about 1.13-1.75 W/mK at about room temperature, and decreased to between about 0.73 - 0.95 W/mK at about 2200°F (1204°C). While we do not foresee using YsCeO₂ with greater than about 60 wt% Ce, we do not rule out using higher ceria concentrations. While YsCeO₂ is slightly more dense than YSZ, about 10 - 15% more dense, the thermal conductivity of YsCeO₂ is typically less than about one half that of YSZ.

In contrast, a sample of 7 wt% YSZ has a generally constant thermal conductivity, of up to about 2.3 W/(m °C) over the same temperature range. As noted above with respect to Fig. 4, YsCeO₂ having up to at least about 12 wt% yttria also has greater phase stability generally than YSZ over the temperatures encountered in gas turbine applications.

In addition, tests performed using YSZ have indicated that as the concentration of yttria increases, the erosion resistance of the material decreases. In one test, samples of YSZ having 7, 12 and 20 wt% yttria were subjected to erosion testing using 27 micron alumina particles at 800 feet per second (244ms⁻¹) and 2000° F (1204°C). The rate of erosion increased from the 7YSZ to the 12YSZ samples, and increased dramatically from the 12YSZ to the 20YSZ samples.

Tests indicate that the addition of some yttria *enhances* the erosion resistance of ceria. Surprisingly, the addition of more yttria in ceria further enhances erosion resistance, in contrast to the trend indicated above for increasing yttria content in YSZ. These tests also indicate that the samples of 7YsCeO₂ are less erosion resistant that 7YSZ, but more erosion resistant than 20YSZ, and accordingly we would expect that YsCeO₂ would also be useful as an abradable, e.g., in an engine air seal and be applied by plasma spraying or other suitable thermal spray process. Moreover, the coefficient of thermal expansion of yttria strengthened ceria more closely follows the expansion of nickel based superalloys, e.g., the substrate, than does YSZ. Accordingly, it is expected that spallation due to different expansion rates will be reduced, particularly where a thinner TBC is applied. Tests confirm that a YsCeO₂ TBC, either applied directly to an alumina layer at a sufficiently high substrate temperature or applied to an intermediate YSZ layer, resists spalling at least as well as 7YSZ.

While the present invention has been described above in some detail, numerous variations and substitutions may be made without departing from the scope of the invention. For example, the weight percentage of one material may be graded through the thickness of the coating, e.g., has a greater concentration of yttria adjacent the exposed surface of the TBC and a greater concentration of ceria adjacent the substrate.

## Claims

1. A superalloy article comprising:
a superalloy substrate (12);
an adherent alumina layer (16) on the substrate surface; and
a layer of material forming a thermal barrier coating (18) over the alumina layer, the as deposited coating (18) being composed of a solid solution of yttria and ceria, with at least about 12 wt% yttria.

2. A superalloy article comprising:
a superalloy substrate (12);
an adherent alumina layer (16) on the substrate surface; and
a ceramic, columnar grain, thermal barrier coating (18) on the alumina layer (16), the coating (18) being composed of a generally homogeneous mixture of yttria and ceria with at least about 12 wt% yttria.

3. The article of claim 1 or 2, wherein the coating (18) comprises between about 12 wt% - 60 wt% yttria.

4. The article of any preceding claim, further comprising:
an intermediate ceramic bond coat (17) on the alumina layer (16), the thermal barrier coating (18) being applied over the intermediate ceramic bond coat.

5. The article of claim 4, wherein said intermediate layer (17) of ceramic is composed of stabilized zirconia.

6. The article of any preceding claim, wherein the composition of the coating (18) is graded through its thickness.

7. An engine air seal comprising an article as claimed in any preceding claim.

8. An apparatus for generating a durable ceramic thermal barrier coating (18) on a superalloy article, the apparatus comprising:
a crucible (30) defining at least two separate receptacles (34,36) for providing separately from one another at least two ceramic target materials for the coating (18); and
means (24) for heating and evaporating two target materials in the separate receptacles to form first and second evaporants, wherein the first and second evaporants form a mixture prior to condensing upon an article, wherein the means (28) for heating and evaporating comprises an electron beam and means for scanning the beam between a first position in which the beam is directed towards one of the receptacles (34) to impinge upon one target material located in the one receptacle and a second position in which the beam is directed towards another receptacle (36) to impinge upon another target material located in the another receptacle.

9. The apparatus of claim 8, wherein the crucible (30) provides at least two circular channels (34,36) as the receptacles for receiving target materials.

10. The apparatus of claim 8 or 9 further comprising:
a coating chamber (22);
the crucible (32) being positioned in the coating chamber (22), and defining at least two distinct channels (34,36) for target materials for the coating,
the channels (34,36) being positioned in spaced relation to enable the first and second evaporants to form a generally homogeneous vapor mixture prior to condensing upon an article in the chamber (20).

11. The apparatus of any claims 8 to 10, wherein the crucible (32) is disk shaped and defines concentric, arcuate receptacles (34, 36), and further comprising:
means (35) for rotating the crucible to continuously provide continuous feed paths for the target materials.

12. A method of generating a ceramic, thermally insulating coating on an article, the method comprising the steps of:
providing a first ceramic target material and a second ceramic target material within a sealed chamber (22), the first and second target materials being provided separately from one another and in spaced relation to an article (10) to be coated;
evaporating the first target material and the second target material and generating a vapor flux of the evaporants by impinging an electron beam upon the target materials and vaporizing the target materials independently of one another by scanning an electron beam between the first target and the second target; and
condensing the flux of the first evaporant and the second evaporant on the article.

13. The method of claim 12, wherein more heat is provided to one of the target materials than to the other of the target materials.

14. The method of claim 12, wherein the beam is scanned so as to impinge upon one of the target materials for a longer duration than another of the target materials.

15. The method of claim 12, wherein the target materials include yttria and ceria.

16. The method of claim 15, wherein the electron beam impinges on the yttria longer than on the ceria.

17. The method of any of claims 12 to 16, wherein the target materials are provided as a gravel having a particle size of at least about 2 mm.

18. The method of claim 17, wherein the target materials are provided as a gravel having a particle size of between about 3-5 mm.

19. The method of any of claims 12 to 18, wherein the electron beam is scanned between the first target and the second target at least three times per second.

20. The method of any of claims 12 to 19, wherein the first target and the second target are provided on separate, endless feedpaths.

21. The method of any of claim 12 to 20, further comprising the step of generating an intermediate layer (17) of ceramic material on the article (10) prior to the step of evaporating.

22. The method of any of claims 12 to 21, wherein the first and second target materials are evaporated and condensed to produce a coating (18) on the article composed of yttria and ceria, with at least about 3 wt% yttria.

23. The method of claim 22, wherein the coating (18) comprises between about 5 - 12 wt% yttria.

## Patentansprüche

1. Superlegierungsgegenstand, aufweisend:
ein Superlegierungssubstrat (12);
eine anhaftende Aluminiumoxidschicht (16) auf der Substratoberfläche; und
eine Schicht aus Material, welche eine Wärmebarrierenbeschichtung (18) über der Aluminiumoxidschicht bildet, wobei die so abgeschiedene Beschichtung (18) aus einer festen Lösung von Yttriumoxid und Ceroxid mit mindestens 12 Gew.-% Yttriumoxid besteht.

2. Superlegierungsgegenstand, aufweisend:
ein Superlegierungssubstrat (12);
eine anhaftende Aluminiumoxidschicht (16) auf der Substratoberfläche; und
eine keramische Wärmebarrierenbeschichtung (18) mit säulenförmigem Gefüge auf der Aluminiumoxidschicht (16), wobei die Beschichtung (18) aus einer generell homogenen Mischung von Yttriumoxid und Ceroxid mit mindestens etwa 12 Gew.-% Yttriumoxid zusammengesetzt ist.

3. Gegenstand nach Anspruch 1 oder 2, wobei die Beschichtung (18) zwischen etwa 12 Gew.-% bis 60 Gew.-% Yttriumoxid aufweist.

4. Gegenstand nach einem der vorangehenden Ansprüche, ferner aufweisend:
eine keramische Verbindungszwischenbeschichtung (17) auf der Aluminiumoxidschicht (16), wobei die Wärmebarrierenbeschichtung (18) über der keramischen Verbindungszwischenbeschichtung aufgebracht ist.

5. Gegenstand nach Anspruch 4, wobei die Zwischenschicht (17) aus Keramik aus stabilisiertem Zirconoxid gebildet ist.

6. Gegenstand nach einem der vorangehenden Ansprüche, wobei sich die Zusammensetzung über ihre Dicke ändert.

7. Triebwerksluftdichtung, aufweisend einen Gegenstand nach einem der vorangehenden Ansprüche.

8. Vorrichtung zum Erzeugen einer haltbaren keramischen Wärmebarrierenbeschichtung (18) auf einem Superlegierungsgegenstand, wobei die Vorrichtung aufweist:
einen Schmelztiegel (30), der mindestens zwei separate Aufnahmen (34, 36) zum separat voneinander Bereitstellen von mindestens zwei keramischen Targetmaterialien für die Beschichtung (18) definiert; und
Mittel (24) zum Erwärmen und Verdampfen von zwei Targetmaterialien in den separaten Aufnahmen, um ein erstes und ein zweites Evaporat zu bilden, wobei das erste und das zweite Evaporat vor dem Kondensieren auf einen Gegenstand eine Mischung bilden bilden, wobei die Mittel (28) zum Erwärmen und Verdampfen einen Elektronenstrahl und Mittel zum Wechsein des Strahls zwischen einer ersten Position, in der der Strahl in Richtung auf eine der Aufnahmen (34) gerichtet ist, um auf ein in dieser Aufnahme angeordnetes Targetmaterial zu treffen, und einer zweiten Position, in der der Strahl auf eine andere Aufnahme (36) gerichtet ist, um auf ein anderes in der anderen Aufnahme angeordnetes Targetmaterial zu treffen.

9. Vorrichtung nach Anspruch 8, wobei der Schmelztiegel (30) mindestens zwei ringförmige Kanäle (34, 36) als die Aufnahmen zum Aufnehmen von Targetmaterial bereitstellt.

10. Vorrichtung nach Anspruch 8 oder 9, ferner aufweisend:
eine Beschichtungskammer (22);
wobei der Schmelztiegel (32) in der Beschichtungskammer (22) positioniert ist, und mindestens zwei voneinander getrennte Kanäle (34, 36) für Targetmaterialien für die Beschichtung definiert,
wobei die Kanäle (34, 36) in beabstandeter Relation positioniert sind, um zu ermöglichen, dass das erste und das zweite Evaporat eine im Wesentlichen homogene Dampfmischung vor dem Kondensieren auf einem Gegenstand in der Kammer (20) bilden.

11. Vorrichtung nach einem der Ansprüche 8 bis 10, wobei der Schmelztiegel (32) scheibenförmig ist und konzentrische, gebogene Aufnahmen (34, 36) definiert und ferner aufweist:
eine Einrichtung (35) zum Drehen des Schmelztiegels, um kontinuierlich kontinuierliche Zuführwege für die Targetmaterialien zu schaffen.

12. Verfahren zum Erzeugen einer keramischen, wärmeisolierenden Beschichtung auf einem Gegenstand, wobei das Verfahren die folgenden Schritte aufweist:
Bereitstellen eines ersten keramischen Targetmaterials und eines zweiten keramischen Targetmaterials in einer abgedichteten Kammer (22), wobei das erste und das zweite Targetmaterial separat voneinander und in beabstandeter Beziehung zu einem zu beschichtenden Gegenstand (10) vorgesehen sind;
Verdampfen des ersten Targetmaterials und des zweiten Targetmaterials und Erzeugen eines Dampfflusses der Evaporate durch das Auftreffenlassen eines Elektronenstrahls auf die Targetmaterialien und Verdampfen der Targetmaterialien unabhängig voneinander durch das Wechseln eines Elektronenstrahls zwischen dem ersten Target und dem zweiten Target; und
Kondensieren des Flusses des ersten Evaporats und des zweiten Evaporats auf dem Gegenstand.

13. Verfahren nach Anspruch 12, wobei mehr Wärme einem der Targetmaterialien als dem anderen Targetmaterial zugeführt wird.

14. Verfahren nach Anspruch 12, wobei der Strahl so gewechselt wird, dass er auf eines der Targetmaterialien für eine längere Dauer trifft als auf das andere der Targetmaterialien.

15. Verfahren nach Anspruch 12, wobei die Targetmaterialien Yttriumoxid und Ceroxid aufweisen.

16. Verfahren nach Anspruch 15, wobei der Elektronenstrahl auf das Yttriumoxid länger trifft als auf das Ceroxid.

17. Verfahren nach einem der Ansprüche 12 bis 16, wobei die Targetmaterialien als eine Schüttung mit einer Partikelgröße von mindestens etwa 2 mm bereitgestellt werden.

18. Verfahren nach Anspruch 17, wobei die Targetmaterialien als eine Schüttung mit einer Partikelgröße von zwischen etwa 3 bis 5 mm bereitgestellt werden.

19. Verfahren nach einem der Ansprüche 12 bis 18, wobei der Elektronenstrahl zwischen dem ersten Target und dem zweiten Target mindestens drei Mal pro Sekunde gewechselt wird.

20. Verfahren nach einem der Ansprüche 12 bis 19, wobei das erste und das zweite Target auf separaten endlosen Zuführwegen bereitgestellt werden.

21. Verfahren nach einem der Ansprüche 12 bis 20, ferner aufweisend den Schritt des Erzeugens einer Zwischenschicht (17) aus Keramikmaterial auf dem Gegenstand (10) vor dem Schritt des Verdampfens.

22. Verfahren nach einem der Ansprüche 12 bis 21, wobei das erste und das zweite Targetmaterial verdampft werden und kondensiert werden, um eine Beschichtung (18) auf dem Gegenstand zu erzeugen, die aus Yttriumoxid und Ceroxid mit mindestens etwa 3 Gew.-% Yttriumoxid zusammengesetzt ist.

23. Verfahren nach Anspruch 22, wobei die Beschichtung (18) zwischen etwa 5 bis 12 Gew.-% Yttriumoxid aufweist.

## Revendications

1. Article en superalliage comprenant :
un substrat de superalliage (12) ;
une couche d'alumine adhésive (16) sur la surface du substrat ; et
une couche de matériau formant un revêtement de barrière thermique (18) sur la couche d'alumine, la couche (18) telle que déposée se composant d'une solution solide d'oxyde d'yttrium et d'oxyde de cérium, avec au moins 12% en poids d'oxyde d'yttrium.

2. Article en superalliage comprenant :
un substrat de superalliage (12) ;
une couche d'alumine adhésive (16) sur la surface du substrat ; et
un revêtement de barrière thermique en céramique à grain colonnaire (18) sur la couche d'alumine (16), le revêtement (18) étant composé d'un mélange généralement homogène d'oxyde d'yttrium et d'oxyde de cérium avec au moins 12% en poids d'oxyde d'yttrium.

3. Article selon la revendication 1 ou 2, dans lequel le revêtement (18) comprend environ de 12% en poids à 60% en poids d'oxyde d'yttrium.

4. Article selon l'une quelconque des revendications précédentes, comprenant en outre :
un revêtement intermédiaire de liaison en céramique (17) sur la couche d'alumine (16), le revêtement de barrière thermique (18) étant appliqué sur le revêtement intermédiaire de liaison en céramique.

5. Article selon la revendication 4, dans lequel ladite couche intermédiaire (17) en céramique est composée de zircone stabilisée.

6. Article selon l'une quelconque des revendications précédentes, dans lequel la composition du revêtement (18) est graduée dans son épaisseur.

7. Joint d'étanchéité à l'air pour moteur comprenant un article tel que revendiqué dans l'une quelconque des revendications précédentes.

8. Appareil pour produire un revêtement de barrière thermique durable en céramique (18) sur un article en superalliage, l'appareil comprenant:
un creuset (30) définissant au moins deux réceptacles séparés (34, 36) pour fournir séparément l'un de l'autre au moins deux matériaux cibles en céramique pour le revêtement (18) ; et
des moyens (24) pour chauffer et faire évaporer deux matériaux cibles dans les réceptacles séparés pour former le premier et le second produits d'évaporation, dans lesquels le premier et le second produits d'évaporation forment un mélange avant de se condenser sur un article, dans lesquels les moyens (28) pour faire chauffer et évaporer comprennent un faisceau d'électrons et des moyens pour balayer le faisceau entre une première position dans laquelle le faisceau est dirigé vers l'un des réceptacles (34) pour toucher un matériau cible situé dans le premier réceptacle et une seconde position dans laquelle le faisceau est dirigé vers un autre réceptacle (36) pour toucher un autre matériau cible situé dans l'autre réceptacle.

9. Appareil selon la revendication 8, dans lequel le creuset (30) fournit au moins deux canaux circulaires (34, 36) comme les réceptacles pour recevoir les matériaux cible.

10. Appareil selon la revendication 8 ou 9 comprenant en outre :
une chambre de revêtement (22);
le creuset (32) étant positionné dans la chambre de revêtement (22), et définissant au moins deux canaux distincts (34, 36) pour les matériaux cibles pour le revêtement,
les canaux (34, 36) étant positionnés de manière espacée pour permettre au premier et au second produits d'évaporation de former un mélange de vapeur généralement homogène avant de se condenser sur un article dans la chambre (20).

11. Appareil selon l'une quelconque des revendications 8 à 10, dans lequel le creuset (32) est en forme de disque et définit des réceptacles concentriques et arqués (34, 36), et comprenant en outre :
des moyens (35) pour faire tourner le creuset pour fournir en continu des voies d'alimentation continues pour les matériaux cibles.

12. Procédé pour la génération d'un revêtement thermique isolant en céramique sur un article, le procédé comprenant les étapes consistant à :
fournir un premier matériau cible en céramique et un second matériau cible en céramique dans une chambre étanche (22), le premier et le second matériaux étant fournis séparément l'un de l'autre et de manière espacée par rapport à un article (10) à revêtir ;
faire évaporer le premier matériau cible et le second matériau cible et générer un flux de vapeur des produits d'évaporation en touchant les matériaux cibles avec un faisceau d'électrons et en vaporisant les matériaux cibles indépendamment l'un de l'autre par le balayage d'un faisceau d'électrons entre la première cible et la seconde cible ; et
condenser le flux du premier produit d'évaporation et du second produit d'évaporation sur l'article.

13. Procédé selon la revendication 12, dans lequel plus de chaleur est fournie à l'un des matériaux cible qu'à l'autre.

14. Procédé selon la revendication 12, dans lequel le faisceau est balayé de manière à toucher l'un des matériaux cibles pendant une période de temps plus longue que l'autre des matériaux cible.

15. Procédé selon la revendication 12, dans lequel les matériaux cibles comprennent de l'oxyde d'yttrium et de l'oxyde de cérium.

16. Procédé selon la revendication 15, dans lequel le faisceau d'électrons touche l'oxyde d'yttrium plus longtemps que l'oxyde de cérium.

17. Procédé selon l'une quelconque des revendications 12 à 16, dans lequel les matériaux cibles sont fournis sous la forme d'un gravier ayant une taille de particules d'environ au moins 2 mm.

18. Procédé selon la revendication 17, dans lequel les matériaux cibles sont fournis sous la forme d'un gravier ayant une taille de particules d'environ 3 à 5 mm.

19. Procédé selon l'une quelconque des revendications 12 à 18, dans lequel le faisceau d'électron est balayé entre la première cible et la seconde cible au moins trois fois par seconde.

20. Procédé selon l'une quelconque des revendications 12 à 19, dans lequel la première cible et la seconde cible sont fournies sur des voies d'alimentation séparées, sans fin.

21. Procédé selon l'une quelconque des revendications 12 à 20, comprenant en outre l'étape de génération d'une couche intermédiaire (17) de matériau céramique sur l'article (10) avant l'étape consistant à faire évaporer.

22. Procédé selon l'une quelconque des revendications 12 à 21, dans lequel le premier et le second matériaux cibles subissent une évaporation et sont condensés pour produire un revêtement (18) sur l'article composé d'oxyde d'yttrium et d'oxyde de cérium, avec au moins 3 % en poids d'oxyde d'yttrium.

23. Procédé selon la revendication 22, dans lequel la couche (18) comprend environ 5 à 12 % en poids d'oxyde d'yttrium.
